# EUROPÄISCHE PATENTANMELDUNG

(11) **EP 3 190 631 A1**
(43) Veröffentlichungstag der Anmeldung: **12.07.2017**
(21) Anmeldenummer: 16150237.2
(22) Anmeldetag: 05.01.2016
(51) Int. Cl.: H01L 31/042, H01L 31/054, A44C 15/00, A44C 17/00, G06F 3/044

(54) **DEKORATIVER VERBUNDKÖRPER MIT TRANSPARENTER, ELEKTRISCH LEITFÄHIGER SCHICHT UND SOLARZELLE**

(71) Anmelder: D. Swarovski KG, 6112 Wattens (AT)
(72) Erfinder: Gapp, Christof, 6071 Aldrans (AT); Scholz, Martin, 6112 Wattens (AT); Altenberger, Ernst, 6114 Kolsass (AT); Mair, Mathias, 6171 Völs (AT); Lexer, Franz, 6094 Axams (AT); Leber, Annemarie, 6263 Fügen (AT)
(74) Vertreter: Moore, Michael Richard

(57) **Zusammenfassung**

Vorgeschlagen wird ein Schmuckelement, enthaltend
(a) einen transparenten Schmuckstein mit facettierter Oberfläche umfassend konvex gekrümmte Bereiche,
(b) eine transparente, elektrisch leitfähige Schicht, die auf der facettierten Oberfläche umfassend die konvex gekrümmten Bereiche aufgebracht ist,
(c) eine wellenlängenselektive Schicht, die
(c1) auf der der facettierten und gekrümmten Oberfläche gegenüberliegenden planaren Seite oder
(c2) auf der photovoltaischen Zelle (d)

aufgebracht ist,
(d) eine photovoltaische Zelle und
(e) einen elektronischen Sensor.

## Beschreibung

### GEBIET DER ERFINDUNG

Die Erfindung betrifft ein Schmuckelement, welches einen facettierten, transparenten Körper umfassend konvex gekrümmte Bereiche, eine wellenlängenselektive Schicht, eine transparente, elektrisch leitfähige Schicht und ein photovoltaisches Element enthält. Das Schmuckelement ist zur Energieversorgung, unter anderem im Bereich tragbarer Elektronik, und zur Funktionssteuerung der Elektronik geeignet.

### STAND DER TECHNIK

Facettierte Schmucksteine wurden bisher nahezu ausschließlich für rein ästhetische Zwecke in Accessoires und auf Textilien eingesetzt, hatten aber kaum funktionale Wirkung. Im Bereich tragbarer Elektronik (sogenannte Wearable Technologies), einem Markt mit enormen Wachstumschancen, fehlen sie, da dieser Bereich von den Anwendern mehr mit Funktionalität als mit Schmuck verbunden wird. Eine der größten Herausforderungen im Bereich der Wearable Technologies, etwa Körpersensoren, Smart-Watches oder Datenbrillen, stellt die Energieversorgung dar, deren abrupter Ausfall die Geräte zu oft unerwarteten Zeitpunkten funktionsunfähig macht. Neben der Energieversorgung ist auch die Funktionssteuerung der Elektronik eine Herausforderung, insbesondere wenn Funktionalität und Ästhetik verbunden werden sollen. Berührungsempfindliche elektronische Schaltungen, wie sie beispielsweise von Touchscreens bekannt sind, ermöglichen eine komfortable Funktionssteuerung elektronischer Geräte mittels Finger oder Eingabestift. Die Eingabeschnittstelle eines elektronischen Gerätes ist der Geräteteil, durch dessen Berührung eine Funktion ausgelöst wird. Schmucksteine, die als Eingabeschnittstelle zur Funktionssteuerung eine exakte berührungsempfindliche elektronische Bedienbarkeit der Geräte ermöglichen und ein dekoratives Aussehen verleihen, fehlen.

Aus der Patentanmeldung US 2013/0329402 ist die Energieversorgung über eine eingebaute Solarzelle für dekorative Elemente bekannt.

Solarzellen werden gemäß der Patentschrift US 4,173,229 auch in Armbändern und Ketten eingesetzt, um einen therapeutisch wirksamen, elektrischen Strom durch den Körper der Schmuckträger zu leiten.

Das deutsche Gebrauchsmuster DE 203 03 952 U1 schlägt die Verwendung von Solarzellen in Alarmverschlüssen zur Sicherung von Schmuck vor.

Die Patentschrift US 7,932,893 beschreibt eine Uhr mit berührungsempfindlichen Sensoren, die der Steuerung eines Computer - Cursors dienen.

In der Patentschrift US 6,868,046 wird eine Uhr mit kapazitiven Tasten offenbart. Die kapazitiven Tasten werden manuell mittels Finger bedient und dienen der Steuerung der Uhrzeiger.

Schmucksteine mit Solarzellen dekorativ anspruchsvoll zu gestalten, ist Gegenstand der europäischen Patentanmeldung mit dem Aktenzeichen 14 191 386. Schmucksteine, die als berührungsempfindliche elektronische Eingabeschnittstellen dienen, sind nicht bekannt. Aufgabe der vorliegenden Erfindung war es, Schmucksteine so zu adaptieren, dass sie sowohl zur Energieversorgung eingesetzt werden können als auch zur Funktionssteuerung elektronischer Geräte geeignet sind.

### BESCHREIBUNG DER ERFINDUNG

Ein erster Gegenstand der vorliegenden Erfindung betrifft ein Schmuckelement, welches
(a) einen transparenten Schmuckstein mit facettierter Oberfläche umfassend konvex gekrümmte Bereiche,
(b) eine transparente, elektrisch leitfähige Schicht, die auf der facettierten Oberfläche umfassend konvex gekrümmte Bereiche aufgebracht ist,
(c) eine wellenlängenselektive Schicht, die auf der
   (c1) der facettierten und gekrümmten Oberfläche gegenüberliegenden planaren Seite oder
   (c2) auf der photovoltaischen Zelle (d)
      aufgebracht ist,
(d) eine photovoltaische Zelle und
(e) einen elektronischen Sensor
enthält. Die Elemente (a) bis (d) sind in einer bevorzugten Ausführungsform mit Klebstoff verbunden.

Ein weiterer Gegenstand der vorliegenden Erfindung ist die Verwendung des erfindungsgemäßen Schmuckelementes zur Energieversorgung und/oder zur Funktionssteuerung elektronischer Geräte, insbesondere von tragbaren elektronischen Geräten. Ebenso sind Gegenstände enthaltend ein erfindungsgemäßes Schmuckelement Gegenstand der Erfindung. Beispielweise kann das Schmuckelement vorteilhaft in sogenannte Activity Tracker eingebaut werden, die somit ebenfalls Gegenstand der Erfindung sind. Weitere Anwendungsmöglichkeiten werden nachfolgend erwähnt.

Überraschenderweise wurde gefunden, dass eine Kombination aus einem transparenten Schmuckstein mit facettierter Oberfläche und umfassend konvex gekrümmten Bereichen, mit einer transparenten, elektrisch leitfähigen Schicht, mit einer wellenlängenselektiven Schicht und einer photovoltaischen Zelle sich als Energiequelle und als Eingabeschnittstelle für die verschiedensten Zwecke eignet. Im Sinne der Erfindung werden die Begriffe photovoltaische Zelle, photovoltaisches (PV) Element und Solarzelle synonym benutzt. Die erfindungsgemäßen Verbundkörper haben nicht nur verbesserte energieversorgende Eigenschaften, sie sind gleichzeitig Schmucksteine mit hoher Brillanz und eignen sich auch für die Funktionssteuerung von elektronischen Geräten.

Die erfindungsgemäße Kombination liefert vielfältige Einsatzmöglichkeiten im Design- und Technologiebereich, als Energiequelle, als Eingabeschnittstelle zur Funktionssteuerung und auch als Schmuckstein. Nachfolgend wird der transparente Schmuckstein mit facettierter Oberfläche umfassend konvex gekrümmte Bereiche auch als optisches Element bezeichnet. Die Schmuckelemente sind hoch brillant und ermöglichen somit nicht nurden Einsatz als Energiequelle und als Eingabeschnittstelle zur Funktionssteuerung, sondern auch als Dekorationselement. Unter Transparenz wird die Fähigkeit von Materie, elektromagnetische Wellen hindurchzulassen (Transmission), verstanden. Ist ein Material für einfallende elektromagnetische Strahlung (Photonen) eines mehr oder weniger breiten Frequenzspektrums transparent, kann diese das Material nahezu vollständig durchdringen, wird also kaum reflektiert und kaum absorbiert. Erfindungsgemäß bevorzugt wird unter Transparenz eine Transmission von wenigstens 60 % des einfallenden Lichtes verstanden, vorzugweise mehr als 70 % und besonders bevorzugt mehr als 80 %. Unter Facettierung wird erfindungsgemäß die Gestaltung einer Oberfläche eines Schmucksteins mit Vielecken oder sogenannten Polygonen (n≥3) verstanden; Facettierungen werden üblicherweise durch Schleifen eines Kristallrohlings erhalten, sind aber auch durch Pressverfahren zugänglich. Die Begriffe konvex und konkav beziehen sich auf eine gedachte einhüllende Fläche oberhalb beziehungsweise unterhalb der Facetten und die Definitionen sind analog zu Linsen in der Optik zu verstehen. Die konvexen und konkaven Bereiche können dabei sowohl symmetrisch als auch asymmetrisch sein.

Mögliche Aufbauweisen des Schmuckelements (Verbundkörper) sind in den Abbildungen (1a) bis (1b) dargestellt, wobei die Bezugszeichen folgende Bedeutung haben:
(1) transparenter Schmuckstein mit facettierter Oberfläche umfassend konvex gekrümmte Bereiche;
(2) photovoltaische Zelle (Solarzelle);
(3) wellenlängenselektive Beschichtung;
(4) Klebstoff;
(5) transparente, elektrisch leitfähige Schicht;
   (5.1), (5.2), (5.3), (5.4), (5.5) und (5.6) Teilbereiche mit elektrisch leitfähiger Schicht;
(6) elektrisch leitfähige Verbindung;
(7) Auswertesensorik;
(8) Berührung mit einem Finger beziehungsweise Eingabestift;
(9) Bewegung in Pfeilrichtung;
(10) Bewegung in geänderter Pfeilrichtung;
(11) gesamtes Schmuckelement.

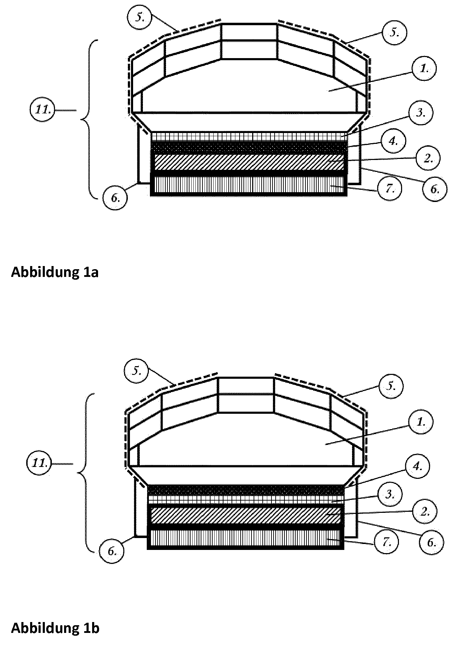

Die transparente, elektrisch leitfähige Schicht (vide infra) ist erfindungsgemäß bevorzugt auf der gekrümmten facettierten Oberfläche des Schmucksteines aufgebracht (Abbildung 1a). Die Schicht (5) ist in Abbildung 1a nicht durchgängig gezeichnet, da sie im Sinne der Erfindung auch in räumlich getrennten Teilbereichen abgeschieden werden kann (vide infra). Die wellenlängenselektive Beschichtung (vide infra) kann sich in einer erfindungsgemäßen Ausführungsform direkt auf der der Facettierung gegenüberliegenden planaren Seite befinden (Abbildung 1a). In einerweiteren erfindungsgemäßen Ausführungsform kann sich die wellenlängenselektive Beschichtung auf der Solarzelle befinden, die mit dem Schmuckstein (1) verklebt wird (Abbildung 1b). Es sei angemerkt, dass eine Verklebung der einzelnen Teile nicht zwingend notwendig ist.

Erfindungsgemäß könnte die wellenlängenselektive Schicht prinzipiell auch auf der facettierten Oberfläche zwischen transparenter, elektrisch leitfähiger Schicht und facettierter Oberfläche aufgebracht werden; allerdings ist dies aufgrund der möglichen Verringerung der Brillanz eine der weniger bevorzugten Ausführungsformen. Wird die wellenlängenselektive Schicht auf der planaren Seite des Schmucksteines aufgebracht, kommt es innerhalb des Schmucksteines zu Mehrfachreflexionen, die zu einer Verstärkung der Brillanz führen. Die photovoltaische Zelle kann ebenso durch Abscheidung beziehungsweise Aufdampfen von Halbleitermaterialien direkt auf dem optischen Element hergestellt werden, muss also nicht notwendigerweise verklebt werden.

Das Schmuckelement bietet die Möglichkeit, verschiedene Geräte aus dem Bereich Wearable Technologies komplett energieautark zu betreiben oder aber deren Laufzeit abhängig vom einfallenden Licht signifikant zu erhöhen.

Die Verbindung des Schmuckelementes mit einer Auswertesensorik (vide infra) ermöglicht die Funktionssteuerung elektronischer Geräte. Durch das Berühren der transparenten, elektrisch leitfähigen Schicht mittels Finger oder einem elektrisch leitfähigen Eingabestift wird ein Signal ausgelöst, das der Funktionssteuerung elektronischer Geräte dient. Gerade bei tragbaren elektronischen Geräten ist aufgrund der geringen Baugröße die Funktionssteuerung der elektronischen Geräte eine Herausforderung. Das erfindungsgemäße Schmuckelement verbindet hohe Brillanz mit einer gut ersichtlichen Eingabeschnittstelle.

Eine Anwendung des Schmuckelements stellen etwa Finger- beziehungsweise Ohrringe dar, bei denen es als Schmuckstein fungiert und gleichzeitig die nötige Energie für eine integrierte Messsensorik samt Sendeeinheit liefert. Derartige Systeme können zur transkutanen, optischen Messung etwa von Laktat, Glucose oder Melatonin im Blut dienen. Das Schmuckelement kann ebenfalls zur Funktionssteuerung der Messsensorik herangezogen werden. Verschiedenste Funktionssteuerungsmöglichkeiten sind denkbar, beispielsweise eine Einschalt- und Ausschaltfunktion oder Umschaltmöglichkeit zwischen verschiedenen Betriebsmodi.

Auch das partielle Aufladen mobiler Geräte, wie beispielsweise von Mobiltelefonen, Laptops, GPS-Systemen oder Tablets ist durch eine Vielzahl von in Serie beziehungsweise parallel geschalteter Schmuckelemente möglich. Das erfindungsgemäße Schmuckelement kann auch Energie für sogenannte schaltbare Effekte zur Verfügung stellen, beispielsweise für eine Farbänderung eines Schmucksteins oder beispielsweise die Displayfunktionen einer sogenannten Smart Watch. Schaltbare Effekte lassen sich mit dem Schmuckelement und einer geeigneten Auswertesensorik (vide infra) durch Berühren der transparenten, elektrisch leitfähigen Schicht des Schmuckelementes, beispielsweise mit einem Finger, steuern. Die Berührung der transparenten, elektrisch leitfähigen Schicht des Schmuckelementes kann beispielsweise die Farbänderung eines Schmucksteines bewirken.

Das Schmuckelement oder eine Mehrzahl von Schmuckelementen kann in ein Armband integriert werden, um beispielsweise eine Smart-Watch oder einen Aktivitätssensor (Activity Tracker) mit Energie zu versorgen. Eine zuverlässige elektrische Verschaltung der Schmuckelemente untereinander kann erreicht werden, wenn man die Schmuckelemente über spezielle Fassungen miteinander verbindet. Eine Energieweiterleitung von den Schmuckelementen zum Produktteil, das die Energie benötigt, ist beispielsweise über einen speziellen Federsteg (hauptsächlich bei Uhren) oder durch Federkontaktstifte (Pogo-Pins) möglich Bei einer Mehrzahl von Schmuckelementen können die einzelnen Schmuckelemente für sich zur Funktionssteuerung herangezogen werden Die Schmuckelemente können auch zur Funktionssteuerung elektronisch miteinander verbunden werden, sodass erst das aufeinanderfolgende Berühren mehrerer Schmucksteine eine Funktion bewirkt (vide infra), zum Beispiel die Helligkeitsregulierung eines Displays und die Lautstärkenregulierung von Lautsprechern.

### TRANSPARENTER SCHMUCKSTEIN MIT FACETTIERTER OBERFLÄCHE UMFASSEND KONVEX GEKRÜMMTE BEREICHE

Der Schmuckstein kann aus einer Vielzahl verschiedenartiger Materialien gefertigt sein, beispielsweise aus transparentem Glas, Kunststoff, transparenter Keramik oder transparenten Edelsteinen oder Halbedelsteinen. Erfindungsgemäß bevorzugt sind facettierte, transparente Schmucksteine, die aus Glas oder aus Kunststoff hergestellt sind, da diese am kostengünstigsten sind und am leichtesten mit Facetten versehen werden können. Erfindungsgemäß besonders bevorzugt ist die Verwendung von Glas. Die Schmucksteine umfassen konvex gekrümmte oder konvex und konkav gekrümmte Bereiche. Dies bedeutet, dass auf der facettierten Seite neben den konvex gekrümmten Bereichen auch konkav gekrümmte Bereiche vorhanden sein können. Die der facettierten Seite gegenüberliegende Seite des Schmucksteins ist entweder plan (bevorzugt) oder aber konkav. Erfindungsgemäß bevorzugt sind Schmucksteine mit plan-konvexer oder plan-konvex/konkaver Geometrie, da sie die kosteneffizienteste Applikation von kristallinen Solarzellen ermöglichen. Besonders bevorzugt sind Schmucksteine mit konvexer, insbesondere plan-konvexer Geometrie.

### Glas

Die Erfindung ist bezüglich der Zusammensetzung des Glases prinzipiell nicht limitiert, solange dieses transparent (vide supra) ist. Unter Glas wird eine eingefrorene unterkühlte Flüssigkeit verstanden, die einen amorphen Festkörper bildet. Erfindungsgemäß können sowohl oxidische Gläser als auch Chalkogenidgläser, metallische Gläser oder nicht-metallische Gläser eingesetzt werden. Auch Oxy-Nitrid-Gläser können geeignet sein. Es kann sich um Einkomponenten- (z.B. Quarzglas) oder Zweikomponenten- (z.B. Alkaliboratglas) oder Mehrkomponentengläser (Kalk-Natron-Glas) handeln. Das Glas kann durch Schmelzen, durch Sol-Gel-Prozesse oder auch durch Stoßwellen hergestellt werden. Die Verfahren sind dem Fachmann bekannt. Erfindungsgemäß bevorzugt sind anorganische Gläser, insbesondere oxidische Gläser. Hierzu gehören Silikatgläser, Boratgläser oder Phosphatgläser. Besonders bevorzugt sind bleifreie Gläser.

Für die Herstellung der facettierten transparenten Schmucksteine werden silikatische Gläser bevorzugt. Silikatische Gläser haben gemeinsam, dass ihr Netzwerk hauptsächlich aus Siliziumdioxid (SiO₂) gebildet wird. Durch Zugabe weiterer Oxide wie beispielsweise Aluminiumoxid oder verschiedener Alkalioxide entstehen die Alumo- oder Alkali-Silikatgläser. Treten als Hauptnetzwerkbildner eines Glases Phosphorpentoxid oder Bortrioxid auf, spricht man von Phosphat- bzw. Boratgläsern, deren Eigenschaften ebenfalls durch Zugabe weiterer Oxide eingestellt werden können. Auch diese Gläser sind im Sinne der Erfindung einsetzbar. Die genannten Gläser bestehen größtenteils aus Oxiden, weshalb man sie zusammenfassend als oxidische Gläser bezeichnet.

In einer erfindungsgemäß bevorzugten Ausführungsform enthält die Glaszusammensetzung folgende Komponenten:
(a) etwa 35 bis etwa 85 Gew.-% SiO₂;
(b) 0 bis etwa 20 Gew.-% K₂O;
(c) 0 bis etwa 20 Gew.-% Na₂O;
(d) 0 bis etwa 5 Gew.-% Li₂O;
(e) 0 bis etwa 13 Gew.-% ZnO;
(f) 0 bis etwa 11 Gew.-% CaO;
(g) 0 bis etwa 7 Gew.-% MgO;
(h) 0 bis etwa 10 Gew.-% BaO;
(i) 0 bis etwa 4 Gew.-% Al₂O₃;
(j) 0 bis etwa 5 Gew.-% ZrO₂;
(k) 0 bis etwa 6 Gew.-% B₂O₃;
(l) 0 bis etwa 3 Gew.-% F;
(m) 0 bis etwa 2,5 Gew.-% Cl.

Alle Mengenangaben sind dabei so zu verstehen, dass sie sich mit gegebenenfalls weiteren Komponenten zu 100 Gewichts-% ergänzen. Die Facettierung der Schmucksteine wird üblicherweise durch Schleif- und Poliertechniken erhalten, die dem Fachmann hinlänglich bekannt sind.

Erfindungsgemäß geeignet ist beispielsweise ein bleifreies Glas, insbesondere das von der Firma Swarovski für die Chessboard Flat Backs verwendete Glas (Katalog-Nr. 2493), welches eine Transmission von > 95 % im Bereich 380 - 1200 nm aufweist.

### Kunststoff

Als weiterer Rohstoff für die Herstellung des facettierten transparenten Schmucksteins (a) können transparente Kunststoffe eingesetzt werden. Erfindungsgemäß geeignet sind alle Kunststoffe, die nach dem Härten der Monomere transparent sind; diese sind dem Fachmann hinlänglich bekannt. Hierfinden unter anderem folgende Materialien Verwendung:
- Acrylglas (Polymethylmetacrylate, PMMA),
- Polycarbonat (PC),
- Polyvinylchlorid (PVC),
- Polystyrol (PS),
- Polyphenylenether (PPO),
- Polyethylen (PE),
- Poly(n-methylmethacrylimid (PMMI).

Die Vorteile der transparenten Kunststoffe gegenüber Glas liegen insbesondere im geringeren spezifischen Gewicht, das nur rund die Hälfte des Glases beträgt. Auch andere Materialeigenschaften sind gezielt einstellbar. Kunststoffe sind zudem oft einfacher zu bearbeiten als Glas. Nachteilig wirkt sich das im Vergleich zu Glas geringe Elastizitätsmodul und die geringe Oberflächenhärte sowie der massive Festigkeitsabfall bei Temperaturen ab ca. 70°C aus. Ein erfindungsgemäß bevorzugter Kunststoff ist Poly(n-methylmethacrylimid), der beispielsweise von Evonik unter dem Namen Pleximid® TT70 vertrieben wird. Pleximid® TT70 hat einen Brechungsindex von 1,54 und einen Transmissionsgrad von 91 %, gemessen nach ISO 13468-2 unter Verwendung von D65-Normlicht.

### Geometrie

Die geometrische Ausgestaltung des facettierten, transparenten Schmucksteins ist prinzipiell nicht limitiert und hängt vorwiegend von Designaspekten ab. Der Schmuckstein ist vorzugsweise quadratisch, rechteckig oder rund. Der facettierte transparente Schmuckstein weist vorzugsweise eine konvexe, insbesondere eine plan-konvexe Geometrie auf (vergleiche Abbildungen 1a und 1b). Vorzugsweise enthält der Schmuckstein eine Vielzahl von Facetten auf der vorzugsweise konvex gekrümmten Seite; bevorzugt sind rechteckige, insbesondere quadratische Facetten, da diese zur Optimierung der Energieausbeute beitragen. Die Geometrie des Schmucksteins mit konvexen und gegebenenfalls zusätzlichen konkaven Bereichen erhöht die Lichtausbeute durch Vergrößerung der gesamten Oberfläche. Während die transparente, elektrisch leitfähige Schicht und die wellenlängenselektive Schicht (vide infra) einen negativen Effekt bezüglich der Lichtausbeute haben, weil ein bestimmter Teil des einfallenden Lichtes reflektiert oder absorbiert wird, wird dieser Verlust durch die spezielle Geometrie mit konvexen und gegebenenfalls konkav gekrümmten Bereichen in Kombination mit den Facetten kompensiert. Insbesondere die konvexe Geometrie des Schmucksteines trägt dazu bei, dass auch die Winkelabhängigkeit der Energieausbeute der Solarzelle entscheidend reduziert wird. Gerade im Hinblick auf tragbare Elektronik, bei der eine Ausrichtung zur Lichtquelle kaum möglich ist, ist eine Reduzierung der Winkelabhängigkeit von sehr großer Bedeutung. Durch die Kombination aus Konvexität und Facettierung werden die Lichtstrahlen auf der Oberfläche des photovoltaischen Elements gebündelt und die Energieausbeute wird deutlich erhöht. Gleichzeitig wird die Winkelabhängigkeit im Vergleich zu einer üblicherweise zum Verkapseln von Solarzellen verwendeten dünnen Platte drastisch reduziert. Durch die konvexe Krümmung und die Facettierung und die daraus resultierende zusätzliche Fläche werden die Lichtstrahlen, die auf das Schmuckelement fallen, zum Lot auf die Solarzelle gebrochen. Durch die Facettierung kommt es zu einer Mehrfachreflexion der Lichtstrahlen (light trapping) und somit zu einer Steigerung der Lichtausbeute.

In einer erfindungsgemäß bevorzugten Ausführungsform beträgt der Oberflächenanteil des konkaven Bereiches maximal ein Drittel der facettierten Gesamtoberfläche des Schmucksteines. In diesem Fall ist die Lichtausbeute einer konvex-konkaven Geometrie ähnlich der einer ausschließlich konvexen Geometrie. Dies konnten Simulationen zeigen (vide infra).

Die Art der Facettierung hängt eng mit der Geometrie des optischen Elementes zusammen. Prinzipiell ist die geometrische Form der Facetten nicht limitiert. Erfindungsgemäß bevorzugt sind quadratische oder rechteckige Facetten, insbesondere in Kombination mit einem quadratisch oder rechteckig dimensionierten transparenten Schmuckstein mit plankonvexer Geometrie. Ebenso können jedoch runde, facettierte Schmucksteine verwendet werden.

### SENSORIK

Durch berührungsempfindliche elektronische Schaltungen, wie sie beispielsweise bei Touchscreens eingesetzt werden, ist die Funktionssteuerung elektronischer Geräte mittels Finger oder elektrisch leitfähigem Eingabestift auf effiziente Art möglich. Erfindungsgemäß bevorzugt enthalten die elektronischen Sensoren kapazitive Sensoren. Als berührungsempfindliche elektronische Schaltung eignet sich eine sogenannte kapazitive Sensorik. Eine kapazitive Sensorik umfasst ein elektronisches Bauteil mit Kondensator und Eingabeschnittstelle. Die Eingabeschnittstelle ist beim Schmuckelement der Schmuckstein mit der elektrisch leitfähigen Schicht. Der Kondensator ändert durch die Berührung der Eingabeschnittstelle mit einem Finger oder einem elektrisch leitfähigen Eingabestift seine Kapazität. Diese Änderung wird elektronisch erfasst und mittels weiterer elektronischer Steuerelemente weiterverarbeitet. Die kapazitive Sensorik und die weiterverarbeitenden elektronischen Steuerelemente werden Auswertesensorik genannt.

Die Kontaktierung von Eingabeschnittstelle und Sensorik wird vorzugsweise durch eine elektrisch leitfähige Verbindung hergestellt. Dies hat den Vorteil, dass keine Beeinträchtigung der Funktionssteuerung auftritt. Im Sinne der Erfindung ist eine elektrisch leitfähige Verbindung beispielsweise durch einen Federkontaktstift möglich. Durch Federdruck auf die elektrisch leitfähige Schicht stellt der Federkontaktstift eine elektrisch leitende Verbindung her. Alternativ kann auch eine elektrisch leitfähige Schmucksteinfassung zur Kontaktierung verwendet werden. Ein elektrisch leitfähiger Teil der Schmucksteinfassung dient beispielsweise der Halterung des Schmucksteines. Die Verbindung von elektrisch leitfähiger Schicht und elektrisch leitfähigem Teil der Schmucksteinfassung stellt die Kontaktierung her.

Alternativ dazu eignet sich als elektrisch leitfähige Verbindung beispielsweise ein elektrisch leitfähiger Klebstoff, zum Beispiel 3MTM 5303 R-25µ / 5303 R-50 µ der Firma 3M, eine elektrisch leitfähige Klebefolie, zum Beispiel 3M^{®} Anisotropic Conductive Film 7379 der Firma 3M oder ein elektrisch leitfähiges Elastomer, zum Beispiel Silver Zebra^{®} Connector der Firma Fuji Polymer Industries Co. LTD. Die elektrisch leitfähige Verbindung kann auch durch eine Kabelverbindung hergestellt werden. Die elektrisch leitfähigen Verbindungsmöglichkeiten sind dem Fachmann hinlänglich bekannt.

### Push- und Slide-Eingabe

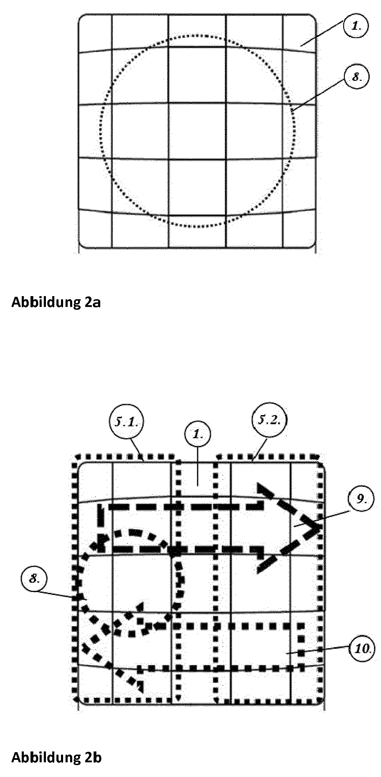

Die Funktionssteuerung der Auswertesensorik mittels transparenter, elektrisch leitfähiger Schicht ist auf verschiedene Arten möglich. Eine Ausführungsform ist die Push-Eingabe. Bei der Push-Eingabe wird durch die Berührung der elektrisch leitfähigen Schicht mit einem Finger oder einem elektrisch leitfähigen Eingabestift (8) eine Funktion der Auswertesensorik ausgelöst, beispielsweise das Ein- oder Ausschalten eines elektronischen Gerätes (Abbildung 2a). Für die Push-Eingabe ist es nicht erforderlich, dass die gesamte gekrümmte facettierte Oberfläche des transparenten Schmucksteines mit der transparenten, elektrisch leitfähigen Schicht beschichtet ist. Die transparente, elektrisch leitfähige Schicht kann auch nur in einem Teilbereich der gekrümmten facettierten Oberfläche aufgebracht sein.

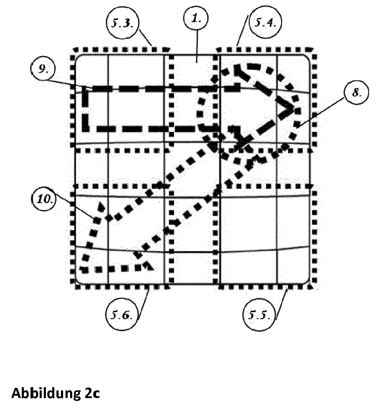

Wird die transparente, elektrisch leitfähige Schicht auf wenigstens zwei getrennten Teilbereichen der gekrümmten facettierten Oberfläche des Schmucksteines aufgebracht (gestrichelte Rechtecke in Abbildungen 2b und 2c) und bewirken die getrennten Teilbereiche unterschiedliche Funktionen, dann ist eine elektrisch leifähige Kontaktierung zwischen den Teilbereichen der transparenten, elektrisch leitfähigen Schicht und der Auswertesensorik erforderlich (Abbildungen 1a und 1b). Ein Teilbereich kann beispielweise zum Ein- und Ausschalten des elektronischen Gerätes dienen, der andere Teilbereich beispielsweise zum Umschalten des Betriebsmodus. Eine Vielzahl von Möglichkeiten zur Funktionssteuerung ergibt sich dadurch. Da Schmuckelemente häufig in eine Fassung eingebaut werden, kann die elektrisch leitfähige Verbindung beispielsweise durch die Fassung erfolgen (vide supra).

Die Slide-Eingabe ist eine weitere Möglichkeit der Funktionssteuerung. Bei dieser Eingabeart ist es erforderlich, dass die transparente, elektrisch leitfähige Schicht auf wenigstens zwei getrennten Teilbereichen der gekrümmten facettierten Oberfläche aufgebracht ist (gestrichelte Rechtecke 5.1 und 5.2 in Abbildung 2b sowie 5.3, 5.4, 5.5 und 5.6 in Abbildung 2c). Die Funktionssteuerung erfolgt durch eine vorgegebene aufeinanderfolgende Berührung der getrennten Teilbereiche mit einem Finger oder einem elektrisch leitfähigen Eingabestift (8 in Abbildungen 2a, 2b und 2c). Der Finger beziehungsweise elektrisch leitfähige Eingabestift bewegt sich in Pfeilrichtung (9 und 10 in Abbildungen 2b beziehungsweise 2c). Diese komfortable Art der Eingabe ist auch von Smartphones bekannt.

Bei der Push- und bei der Slide-Eingabe ist daher für eine komfortable Funktionssteuerung die transparente, elektrisch leitfähige Schicht in wenigstens zwei getrennten Teilbereichen von Vorteil, vorzugsweise wird daher die transparente, elektrisch leitfähige Schicht auf wenigstens zwei getrennten Teilbereichen der gekrümmten facettierten Oberfläche des Schmucksteines aufgebracht. Weitere Funktionssteuerungsmöglichkeiten ergeben sich, wenn die Push- und die Slide-Eingabe bei einem Schmuckelement kombiniert werden, beispielsweise eine Slide-Eingabe mit den räumlich getrennten Teilbereichen 5.3, 5.4, 5.6 und eine Push-Eingabe mit dem Teilbereich 5.5 (Abbildung 2c). Für die Push- und die Slide-Eingabe können auch mehrere Schmuckelemente miteinander verbunden werden, sodass beispielsweise das aufeinanderfolgende Berühren von verschiedenen Schmuckelemente eine Funktion auslöst.

Erfindungsgemäße Schmuckelemente die eine Push- und/oder Slide-Eingabe vorweisen, können beispielsweise bei Armbändern, Ringen, Halsketten, Broschen, Taschen, Headsets oder Activity Trackern eingesetzt werden. Schmuckstücke, wie beispielsweise Armbänder, Ringe, Halsketten oder Broschen, können selbst elektronische Geräte enthalten. Diese elektronischen Geräte haben beispielsweise schaltbare Funktionen, wie zum Beispiel Lichteffekte, oder können als Fernbedienung (Remote Control) für beispielsweise Smartphones, Headsets oder Activity-Trackern verwendet werden. Bei einem Smartphone ist beispielsweise eine Funktionssteuerung möglich, bei der Anrufe durch Berührung des Schmuckelementes angenommen oder abgelehnt werden, bei einem Headset ist eine Lautstärkenregulierung denkbar und bei einem Activity-Tracker das Umschalten zwischen den Betriebsmodi. Die Anwendungsbereiche und die Funktionssteuerungsmöglichkeiten sind nur beispielhaft angegeben, umsetzbar ist eine Vielzahl von steuerbaren Funktionen.

### TRANSPARENTE, ELEKTRISCH LEITFÄHIGE SCHICHT

Die transparente, elektrisch leitfähige Schicht ermöglicht in Verbindung mit einer Auswertesensorik die Funktionssteuerung elektronischer Geräte. Sie ist erfindungsgemäß bevorzugt auf der gekrümmten facettierten Oberfläche des Schmucksteines aufgebracht, um eine leichte Berührung mit einem Finger oder einem elektrisch leitfähigen Eingabestift zu ermöglichen. Die Transmissionseigenschaften der transparenten, elektrisch leitfähigen Schicht können sowohl das brillante Erscheinungsbild als auch die Wirkung der Solarzelle beeinflussen. Vorzugsweise ist daher die transparente elektrisch leitfähige Schicht im Bereich von 380 - 1200 nm transparent, besonders bevorzugt im Bereich von 380 - 850 nm. Erfindungsgemäß bevorzugt hat die transparente, elektrisch leitfähige Schicht eine Transparenz (vide supra) von wenigstens 60 %, besonders bevorzugt von wenigstens 70 % und ganz besonders bevorzugt von wenigstens 80 %.

Metallische Schichten eignen sich aufgrund ihrer elektrischen Leitfähigkeit als elektrisch leitfähige Schicht. Sie lassen sich durch geeignete Beschichtungsverfahren, beispielsweise Sputtern (vide infra), auf dem Schmuckstein abscheiden. Metalle, wie beispielsweise Cr, Ti, Zr, V, Mo, Ta und W sind hierfür geeignet. Als elektrisch leitfähige Schicht sind Metalle, wie Al, Cu oder Ag aufgrund ihrer geringeren chemischen Beständigkeit weniger vorteilhaft. Chemische Verbindungen mit elektrisch leitenden Eigenschaften sind ebenfalls als elektrisch leitfähige Schicht verwendbar, insbesondere chemische Nitridverbindungen, zum Beispiel TiN, TiAlN oder CrN. Die Transparenz der Schichten kann durch die Dicke der aufgetragenen Schicht und die Anzahl der Schichten verändert werden. Die metallischen Schichten und die elektrisch leitenden chemischen Verbindungen sind dem Fachmann hinlänglich bekannt.

Transparente, elektrisch leitfähige Oxidschichten sind ebenso als transparente, elektrisch leitfähige Schicht einsetzbar. Sie sind dem Fachmann wohl bekannt. Transparente, elektrisch leitfähige Oxidschichten haben eine gute mechanische Abriebfestigkeit, eine gute chemische Beständigkeit und gute thermische Stabilität. Sie enthalten halbleitende Oxide. Die halbleitenden Oxide erhalten durch eine geeignete n-Dotierung eine metallische Leitfähigkeit. Die transparenten, elektrisch leitfähigen Oxidschichten sind beispielsweise in Flachbildschirmen oder Dünnschichtsolarzellen wichtige Komponenten für transparente Elektroden.

Indiumzinnoxid ist die technisch am besten zugängliche transparente elektrisch leitfähige Oxidschicht. Sie ist ein handelsübliches Mischoxid aus circa 90 % In₂O₃ und ca. 10 % SnO₂. Indium-Zinn-Oxid hat sehr gute Transmissionseigenschaften, eine sehr gute mechanische Abriebfestigkeit sowie eine sehr gute chemische Beständigkeit. Vorzugsweise wird Indiumzinnoxid mit einer Schichtdicke von wenigstens 4 nm aufgetragen, um eine elektrische Leitfähigkeit zu erhalten.

Aluminium dotiertes Zinkoxid als transparente, elektrisch leitfähige Oxidschicht hat gute Transmissionseigenschaften und eine gute mechanische Abriebfestigkeit. Es wird beispielsweise im Bereich der Solarindustrie großtechnisch eingesetzt. Weitere geeignete transparente, elektrisch leitfähige Oxidschichten sind dotierte Zink-Oxide, wie Gallium-Zink-Oxid oder Titan-Zink-Oxid, dotierte Zinn-Oxide, wie Fluor-Zinn-Oxid, Antimon-Zinn-Oxid oder Tantal-Zinn-Oxid oder dotiertes Titan-Niob-Oxid.

Erfindungsgemäß bevorzugt umfasst die elektrisch leitfähige Schicht wenigstens eine Komponente, die gebildet wird von Cr, Ti, Zr, Indiumzinnoxid, Aluminiumdotiertem Zinkoxid, Gallium-Zink-Oxid, Titan-Zink-Oxid, Fluor-Zinn-Oxid, Antimon-Zinn-Oxid Tantal-Zinn-Oxid oder Titan-Niob-Oxid, oder eine beliebige Kombination dieser Komponenten in einer beliebigen Schichtabfolge. Besonders bevorzugt wird als elektrisch leitfähige Schicht nur Indiumzinnoxid aufgetragen.

Die Verfahren zur Herstellung von transparenten, elektrisch leitfähigen Schichten sind dem Fachmann hinlänglich bekannt. Hierzu zählen unter anderem PVD (physical vapour deposition) und CVD (chemical vapour deposition) Verfahren. Erfindungsgemäß bevorzugt sind PVD-Verfahren.

Bei den PVD-Methoden handelt es sich um eine Gruppe von vakuumbasierten Beschichtungsverfahren beziehungsweise Dünnschichttechnologien, die dem Fachmann hinlänglich bekannt sind und insbesondere zur Beschichtung von Glas und Kunststoff in der Optik- und der Schmuckindustrie eingesetzt werden. Im PVD-Prozess wird das Beschichtungsmaterial in die Gasphase überführt. Das gasförmige Material wird anschließend zum zu beschichtenden Substrat geführt, wo es kondensiert und die Zielschicht bildet. Mit einigen dieser PVD-Verfahren (Magnetronsputtern, Laserstrahlverdampfen, thermische Bedampfung, etc.) können sehr niedrige Prozesstemperaturen verwirklicht werden. Eine Vielzahl von Metallen kann auf diese Weise in sehr reiner Form in dünnen Schichten abgeschieden werden. Führt man den Prozess in Gegenwart von Reaktivgasen wie Sauerstoff durch, so lassen sich auch Metalloxide abscheiden. Ein erfindungsgemäß bevorzugtes Verfahren ist ein Beschichtungsprozess mittels Sputtern, beispielsweise mit dem Gerät Radiance der Firma Evatec. Ein typisches Schichtsystem kann je nach Anforderung an Funktion und optische Erscheinung aus nur einer, aber auch aus einer Vielzahl von Schichten bestehen.

Für die Herstellung der getrennten Teilbereiche der transparenten, elektrisch leitfähigen Schicht auf der gekrümmten facettierten Oberfläche (vide supra) wird der Schmuckstein mit einer Maskierung abgedeckt. Die Maskierung lässt die Teilbereiche der gekrümmten facettierten Oberfläche frei, auf die die transparente, elektrisch leitfähige Schicht abgeschieden wird. Als Maskierung eignen sich beispielsweise Abdeckungen aus Kunststoff oder Metall. Eine alternative Möglichkeit zur Herstellung der getrennten Teilbereiche der transparenten, elektrisch leitfähigen Schicht auf der gekrümmten facettierten Oberfläche ist die Durchtrennung dieser Schicht in Teilbereiche mittels Laser, beispielsweise einem Nd:YAG Laser oder einem Ultrakurzpulslaser. Die Verwendung eines Lasers ermöglicht eine sehr präzise Herstellung der getrennten Teilbereiche. Die Trennung der transparenten, elektrisch leitfähigen Schicht kann auch durch Ätzen erfolgen. Beim Ätzen wird beispielsweise mittels Fotolack eine Maskierung auf der transparenten, elektrisch leitfähigen Schicht aufgebracht. Durch das Ätzen werden die gewünschten räumlich getrennten Teilbereiche der transparenten, elektrisch leitfähigen Schicht hergestellt. Der Fotolack wird anschließend beispielsweise nasschemisch entfernt. Die Methoden sind dem Fachmann hinlänglich bekannt.

### WELLENLÄNGENSELEKTIVE SCHICHT

Die wellenlängenselektive Schicht ermöglicht, dass das Schmuckelement Brillanz aufweist. Die wellenlängenselektive Schicht befindet sich bevorzugt zwischen dem transparenten, facettierten Schmuckstein umfassend konvex gekrümmte Bereiche und dem photovoltaischen Element. Sie wird erfindungsgemäß bevorzugt auf zwei verschiedene Weisen verwirklicht: durch eine wellenlängenselektive Folie oder aber durch eine wellenlängenselektive Beschichtung, die durch PVD, CVD oder nasschemische Verfahren hergestellt wird. Eine wellenlängenselektive Schicht kann aber ebenso durch eine mikrostrukturierte Oberfläche erhalten werden. Die Methoden zur Mikrostrukturierung sind dem Fachmann wohl bekannt.

Durch die Reflexion eines definierten Bereichs (=Filtern) des sichtbaren Spektrums gewinnt das optische Element an Brillanz und erscheint für den Betrachter in einer bestimmten Farbe. Durch die Facettierung des Schmucksteines wird die Brillanz zusätzlich unterstützt. In einer bevorzugten Ausführungsform der Erfindung reflektiert die wellenlängenselektive Schicht einen Anteil des Lichtes im Bereich von 380-850 nm, das heißt im vorwiegend sichtbaren Bereich. Der Anteil des Lichtes, der reflektiert wird, liegt dabei in einem möglichst schmalen Bereich des sichtbaren Spektrums, typischerweise in einem nicht mehr als 50-250 nm breiten Intervall. Einerseits ist dieser Anteil ausreichend, um das dekorative Element hinsichtlich der Brillanz als Schmuckstein wahrzunehmen. Andererseits werden Verluste in der Energieausbeute, resultierend aus dem reflektierten Wellenlängenbereich, minimiert. Erfindungsgemäß bevorzugt ist es daher, dass die wellenlängenselektive Schicht das einfallende Licht in einem 50-250 nm breiten Reflexionsintervall, welches im Bereich von 380 - 850 nm liegt, wenigstens zu 50 % reflektiert. Vorzugsweise ist das Reflexionsintervall 50 - 200 nm breit, besonders bevorzugt 50 -150 nm. In einer weiteren bevorzugten Ausführungsform hat die wellenlängenselektive Schicht außerhalb des Reflexionsintervalls eine durchschnittliche Transmission von > 60 %, vorzugsweise > 80% im Wellenlängenbereich von 400-1200 nm, gemessen bei einem Einfallswinkel der Lichtstrahlen von 0°. Vorzugsweise ist die wellenlängenselektive Schicht auf der Seite des Schmucksteines aufgebracht, die der facettierten Seite gegenüberliegt; alternativ kann sie auch direkt auf das photovoltaische Element aufgebracht werden.

Die photovoltaische Zelle (Solarzelle) kann nur einen Teil des Sonnenspektrums nutzen. Die wellenlängenselektive Schicht, die als Filter wirkt, reflektiert vorzugsweise zusätzlich den Teil des Spektrums, der im IR-Bereich liegt und von der Solarzelle nicht mehr genutzt werden kann und verhindert somit eine zusätzliche Erwärmung der Solarzelle.

Üblicherweise verlieren Solarzellen 0,47 % an Energieausbeute pro °C Erwärmung, so dass die korrekte Wahl der Beschichtung von hoher Bedeutung ist. Je kürzer die einfallende Wellenlänge ist desto höher ist die Energie der Photonen (E=h·-ν [eV]). Bei Silizium-Solarzellen wird eine Energie von 1.1eV benötigt um ein Elektronen Loch-Paar aus dem p/n Übergang zu schlagen; die überschüssige Energie wird in Wärme umgewandelt. Wenn beispielsweise ein Photon mit 3.1eV entsprechend der Energie bei 400 nm auf die Zelle eintrifft, werden 2eV in Wärmeenergie umgewandelt und führen zu einer Reduzierung der Energieausbeute. Daher ist es erfindungsgemäß besonders vorteilhaft den kurzwelligen blauen beziehungsweise grünen Anteil zu reflektieren (Wellenlänge: 380-490 nm), da hier am meisten Wärme erzeugt wird. Prinzipiell ist es durch die wellenlängenselektive Schicht möglich, Schmuckelemente mit den verschiedensten Farben zu generieren. Um die Energieausbeute zu optimieren, ist es jedoch bevorzugt, dass die wellenlängenselektive Schicht einen Anteil aus dem kurzwelligen Bereich des sichtbaren Spektrums reflektiert.

Die wellenlängenselektive Schicht zeigt eine winkelabhängige Reflexion. Das Reflexionsintervall verschiebt sich je nach Einfallswinkel des Lichtes auf die Facetten. In Abhängigkeit von der Lage der Facetten werden unterschiedliche Farbanteile reflektiert und es entsteht ein annähernd irisierender Effekt, das heißt eine graduelle Farbveränderung von Facette zu Facette, die mit einer plan-konvexen Linse ohne Facetten nicht erreicht werden kann.

Die wellenlängenselektive Schicht ist vorzugsweise zumindest partiell für UV-Licht durchlässig, um auch eine Verklebung der einzelnen Komponenten des Schmuckelementes mit UV-härtenden Klebstoffen zu ermöglichen.

### Wellenlängenselektive Folien

Wellenlängenselektive Folien werden unter dem Begriff Radiant Light Film im Handel vertrieben. Hierbei handelt es sich um mehrschichtige polymere Filme, die auf andere Materialien appliziert werden können. Diese Lichtfolien sind Bragg-Spiegel und reflektieren einen hohen Anteil des sichtbaren Lichts und erzeugen brillante farbige Effekte. Eine reliefartige Mikrostrukturierung im Bereich von mehreren hundert Nanometern reflektiert die verschiedenen Wellenlängen des Lichtes Licht und es kommt zu Interferenzerscheinungen, wobei sich die Farben je nach Blickwinkel ändern.

Erfindungsgemäß besonders bevorzugte Folien bestehen aus mehrschichtigen polymeren Filmen, deren äußere Schicht ein Polyester ist. Solche Filme werden beispielsweise von der Firma 3M unter dem Namen Radiant Color Film CM 500 und CM 590 vertrieben. Die Filme haben ein Reflexionsintervall von 590 - 740 beziehungsweise 500 - 700 nm.

Die wellenlängenselektive Folie wird vorzugsweise mittels eines Klebstoffs mit der photovoltaischen Zelle und dem facettierten transparenten Schmuckstein verbunden. Der Klebstoff sollte ebenfalls transparent sein. In einer bevorzugten Ausführungsform weicht der Brechungsindex des Klebstoffs weniger als ± 20 % von dem Brechungsindex des facettierten, transparenten Körpers mit konvexer Geometrie ab. In einer besonders bevorzugten Ausführungsform ist die Abweichung < 10 %, ganz besonders bevorzugt < 5 %. Nur auf diese Weise wird gewährleistet, dass Reflexionsverluste aufgrund der unterschiedlichen Brechungsindizes minimiert werden können. Die Brechungsindices können auch durch Aufrauhung der jeweiligen Grenzschichten aneinander angepasst werden (Mottenaugeneffekt). Sogenannte Mottenaugenoberflächen bestehen aus feinen Noppenstrukturen, die das Brechungsverhalten des Lichtes nicht schlagartig, sondern idealerweise kontinuierlich verändern. Dadurch werden die scharfen Grenzen zwischen den unterschiedlichen Brechzahlen beseitigt, so dass der Übergang fast fließend erfolgt und das Licht ungehindert hindurch dringen kann. Die Strukturgrößen, die dafür erforderlich sind, müssen kleiner als 300 nm sein. Durch Mottenaugeneffekte wird sichergestellt, dass die Reflexion an den Grenzschichten minimiert wird und somit eine höhere Lichtausbeute beim Durchgang durch die Grenzschichten erzielt wird.

Klebstoffe, die mittels UV ausgehärtet werden können, sind erfindungsgemäß bevorzugt. Dem Fachmann sind sowohl die UV-härtenden Klebstoffe wohl bekannt als auch die Verfahren zur Bestimmung des Brechungsindex. Erfindungsgemäß besonders bevorzugt ist die Verwendung von Acrylat-Klebstoffen, insbesondere von modifizierten Urethanacrylat-Klebstoffen. Diese werden von zahlreichen Firmen vertrieben, beispielsweise von Delo unter der Bezeichnung Delo-Photobond^{®} PB 437, ein Klebstoff, der durch UV-Licht im Bereich von 320-42 nm ausgehärtet werden kann.

### Wellenlängenselektive Beschichtung

Die Beschichtungsmaterialien sind dem Fachmann wohl bekannt. In einer bevorzugten Ausführungsform der Erfindung enthalten die wellenlängenselektiven Beschichtungen wenigstens ein Metall und/oder eine Metallverbindung, wie beispielsweise Metalloxide, Metallnitride, Metallfluoride, Metallcarbide oder eine beliebige Kombination dieser Verbindungen in beliebiger Reihenfolge, die mittels einer der gängigen Beschichtungsverfahren auf die facettierten Schmucksteine aufgebracht werden. Es können auch aufeinanderfolgende Schichten verschiedener Metalle oder Metallverbindungen aufgebracht werden. Die Verfahren zur Herstellung von Beschichtungen sowie die Beschichtungen selbst sind dem Fachmann hinlänglich bekannt. Hierzu zählen unter anderem PVD (physical vapour deposition), CVD (chemical vapour deposition), Lackieren sowie nasschemische Verfahren gemäß Stand der Technik. Erfindungsgemäß bevorzugt sind PVD-Verfahren (vide supra).

Als Beschichtungsmaterialien sind erfindungsgemäß insbesondere Cr, Cr₂O₃, Ni, NiCr, Fe, Fe₂O₃, Al, Al₂O₃, Au, SiOₓ, Mn, Si, Si₃N₄, TiOₓ, Cu, Ag, Ti,CeF₃, MgF₂, Nb₂O₅, Ta₂O₅, SnO₂, ZnO₂, MgO, CeO₂, WO₃, Pr₂O₃, Y₂O₃; BaF₂, CaF₂, LaF₃, NdF₃, YF₃; ZrO₂, HfO₂, ZnS, Oxinitride von Al, Si, sowie SnZnO geeignet.

Ist die wellenlängenselektive Beschichtung elektrisch leitfähig, wie das beispielsweise bei metallische Beschichtungen wie Cr, Ni, Fe, Al, Au, Mn, Si, Cu, oder Ag der Fall ist, kann es bei direkter Verbindung von elektrischer leitfähiger Schicht und elektrisch leitfähiger, wellenlängenselektiven Beschichtung zu störenden elektrischen Strömen kommen. Die störenden elektrischen Ströme sind Fehlströme, die durch die Verbindung von elektrisch leitfähiger Schicht und elektrisch leitfähiger, wellenlängenselektiven Beschichtung auftreten können. Die Fehlströme sind beispielsweise bei der Slide-Eingabe möglich. Bei der Push-Eingabe sind sie dann möglich, wenn Teilbereiche der elektrisch leitfähigen Schicht unterschiedliche Funktionen auslösen (vide supra). Ist die elektrisch leitfähige Schicht mit der elektrisch leitfähigen, wellenlängenselektiven Beschichtung verbunden, wird daher vorzugsweise die elektrisch leitfähige, wellenlängenselektive Beschichtung elektrisch isoliert, indem die elektrisch leitfähige, wellenlängenselektive Beschichtung in Teilbereiche aufgeteilt wird. Die Verfahren zu Herstellung der Teilbereiche der elektrisch leitfähigen, wellenlängenselektiven Beschichtung sind dem Fachmann hinlänglich bekannt (vide supra).

Um eine wellenlängenselektive Beschichtung zu erhalten, können beispielweise absorbierende Materialien verwendet werden, die aufgrund ihres Absorptionsverhaltens wellenlängenselektiv nur gewisse Anteile des sichtbaren Lichtes transmittieren beziehungsweise reflektieren und dadurch farbig sind. Erfindungsgemäß bevorzugt geeignet sind Schichtsysteme, die aus dielektrischen Materialien aufgebaut sind und aufgrund von Interferenzerscheinungen nur gewisse Anteile des sichtbaren Lichtes transmittieren bzw. reflektieren und dadurch farbig wirken, beispielsweise eine Vielfach-Abfolge von TiO₂ und SiO₂. Eine erfindungsgemäß besonders bevorzugte wellenlängenselektive Beschichtung besteht aus einer alternierenden Abfolge von TiO₂ und SiO₂ in zwölf Schichten und Schichtdicken, die zwischen ca. 20-145 nm variieren. Erfindungsgemäß bevorzugt sind sogenannte Bandsperrfilter mit den Kantenlagen 380 und 480 nm, das heißt dass im Bereich 380-480 nm der größte Anteil des Lichtes reflektiert wird (=Reflexionsintervall). Zur Herstellung von Bandsperrfiltern anderer Kantenlagen werden Schichtanzahl und Schichtdicke variiert. Für die PVD-Schichterzeugung steht eine Vielzahl handelsüblicher Maschinen zur Verfügung, beispielsweise das Modell BAK1101 der Firma Evatec.

### PHOTOVOLTAISCHES ELEMENT

Das photovoltaische Element (Solarzelle) ist ein elektrisches Bauelement, das kurzwellige Strahlungsenergie, in der Regel Sonnenlicht, direkt in elektrische Energie umwandelt. Welche Art von Solarzelle einsetzbar ist, hängt von der erforderlichen Energieversorgung sowie dem speziellen Applikationszweck ab. Für den erfindungsgemäßen Applikationszweck eignen sich insbesondere anorganische Solarzellen. Sie werden aus Halbleitermaterialien, am häufigsten aus Silicium, gefertigt. Daneben finden unter anderem auch Cadmiumtellurid, Kupfer-Indium-Gallium-Diselenid und Galliumarsenid Anwendung. Bei sogenannten Tandem-Solarzellen werden Schichten unterschiedlicher Halbleiter verwendet, beispielsweise Indiumgalliumarsenid in Kombination mit Indiumgalliumphosphid.

Neben dem Material ist die Bauweise der Solarzelle von Bedeutung. Stapeltechniken mit Materialkombinationen werden beispielsweise verwendet, um den Wirkungsgrad der Gesamtanordnung zu erhöhen. Die Materialien werden so gewählt, dass das einfallende Sonnenspektrum maximal ausgenutzt wird. Während der theoretisch erreichbare Wirkungsgrad bei circa 43 % liegt, werden in der Realität in Standard-Solarzellen nur ca. 15 bis 20 % erreicht. Verluste entstehen durch Rekombination der Ladungsträger und einhergehender Wärmeerzeugung, durch Reflexion sowie aufgrund des Serienwiderstandes. Die elektrische Spannung bei maximaler Leistung (Maximum Power Point, Leistungsanpassung) liegt bei den gebräuchlichsten Zellen (kristalline Siliziumzellen) bei etwa 0,5 V.

Die Struktur von Solarzellen wurde in den letzten Jahren optimiert, so dass möglichst viel Licht absorbiert wird und in der aktiven Schicht freie Ladungsträger erzeugt werden. Dazu wird eine Antireflexionsschicht auf die Oberseite der Solarzelle aufgetragen während die Rückseite verspiegelt wird. Die Antireflexionsschicht sorgt für die typisch bläuliche bis schwarze Farbe von Solarzellen. Die Antireflexionsschicht wird häufig aus Siliciumnitrid, Siliciumdioxid und Titandioxid hergestellt. Über die Schichtdicke der Antireflexbeschichtung wird auch die Farbe bestimmt (Interferenzfarbe). Eine gleichmäßige Schichtdicke ist wichtig, da bereits Schwankungen im Nanometer-Bereich den Reflexionsgrad erhöhen. Blaue Reflexion ergibt sich aus der Einstellung der Antireflexschicht auf den roten Teil des Spektrums - der bevorzugten Absorptionswellenlänge des Siliciums. Siliciumnitrid und Siliciumdioxid als Antireflexschicht-Materialien fungieren zusätzlich als Passivierungsschicht, die die Rekombination von Ladungsträgern an der Oberfläche herabsetzt, so dass mehr Ladungsträger zur Stromerzeugung zur Verfügung stehen. Eine weitere Effizienzsteigerung erreicht man, wenn man die frontseitigen Kontaktfinger auf der Rückseite der Solarzelle anbringt. Hierdurch wird die Abschattung auf der Frontseite vermieden, die eine geringere aktive Fläche und folglich eine geringere Lichtausbeute zur Folge hat, da bis zu 10 % der Oberfläche von den Metallkontakten bedeckt ist. Rückseitige Kontaktfinger sind darüber hinaus leichter und verlustärmer elektrisch kontaktierbar als frontseitige Kontaktfinger. Erfindungsgemäß bevorzugt sind rückseitenkontaktierte Solarzellen. Diese sogenannten IBC-Zellen (Interdigitated Back Contact Cells) werden beispielsweise von der Firma SunPower vermarktet. Erfindungsgemäß geeignet sind insbesondere Solarzellen aus monokristallinem Silicium und einer Antireflexbeschichtung aus Siliciumnitrid; vorzugsweise weisen die Solarzellen eine Effizienz > 20 % auf. Erfindungsgemäß besonders geeignet ist die Sunpower^{®} C60-Solarzelle aus monokristallinem Silizium, die sich durch eine Effizienz von circa 22.5 % auszeichnet. Die Antireflexbeschichtung aus Siliziumnitrid (Si₃N₄) hat typischerweise einen Brechungsindex von 1,9-2,5. Zur Effizienzsteigerung der Solarzellen tragen unter anderem eine Rückseitenkontaktierung, eine Rückseitenverspiegelung, eine Passivierungsschicht aus Siliciumdioxid sowie die Verwendung von n-dotiertem Silicium bei.

Die erfindungsgemäß einsetzbare Größe/Fläche der Solarzelle und des erfindungsgemäßen Schmuckelementes ist von der Anwendung und von der Bestrahlungsstärke abhängig. Bei einer Fläche von 1 cm² und einer Zelleneffizienz von circa 20 % lassen sich bei einer Bestrahlungsstärke von 100 mW/cm² in direktem Sonnenlicht innerhalb einer Stunde theoretisch bis zu 20 mWh an Energie sammeln. In der Praxis wird dieser Wert aufgrund von Absorptionsverlusten durch die transparente, elektrisch leitfähige Schicht, Reflexionsverlusten durch die wellenlängenselektive Schicht, elektrischer Verluste beim Laden des Energiespeichers - sowie der Tatsache, dass eine durchschnittliche Bestrahlungsstärke von circa 100 mW/cm² beziehungsweise 1000 W/m² in Mitteleuropa nicht häufig erreicht wird - etwas niedriger ausfallen. Bezogen auf einen am Markt erhältlichen Activity Tracker, der eine durchschnittliche Entladung von circa 3 mWh/Tag aufweist, würde bei einer Fläche von 1 cm² Solarzelle eine Bestrahlungsdauer von einer Stunde pro Woche in direktem Sonnenlicht ausreichen. Aufgrund der guten Performance der IBC-Solarzellen auch unter nicht-optimalen Lichtbedingungen ist auch eine Verwendung in Innenräumen ausreichend, um einer Entladung dertragbaren elektronischen Geräte entgegenzuwirken. Im Vergleich zu direktem Sonnenlicht im Freien, ist die Bestrahlungsstärke in Räumen um den Faktor 100-200 geringer. Die anfangs genannten Sensoren zur Überwachung von Körperfunktionen zeigen eine durchschnittliche Entladung von circa 1 bis 5 mWh/Tag. Auch hier ist eine Energieversorgung über das erfindungsgemäße Schmuckelement möglich, beispielsweise durch Integration des Schmuckelementes oder einer Vielzahl solcher Elemente in Schmuck-Designs.

In einer bevorzugten Ausführungsform der Erfindung ist das photovoltaische Element mit elektrischen Kontakten versehen, um die generierten elektrischen Ladungsträger in Form von Strom abzuleiten. Dabei werden die rückseitigen elektrischen Kontakte der Solarzelle über eine Leiterplatte kontaktiert und zu einem positiven und einem negativen Kontakt zusammengeführt.

Die Erfindung wird nachfolgend an Hand von Beispielen und Abbildungen näher illustriert ohne darauf beschränkt zu sein. Die Abbildungen zeigen folgende Gegenstände:
- **Abb. 1:**: Aufbau eines Schmuckelements
- **Abb. 1a:**: Elektrisch leitfähige Schicht in Teilbereichen des Schmucksteines und wellenlängenselektive Beschichtung auf der der Facettierung gegenüberliegenden planen Seite.
- **Abb. 1b:**: Elektrisch leitfähige Schicht in Teilbereichen des Schmucksteines und wellenlängenselektive Beschichtung auf der Solarzelle.
- **Abb.2:**: Funktionssteuerung des Schmuckelements
- **Abb. 2a:**: Schmuckelement und Funktionssteuerung mittels Eingabe durch Finger beziehungsweise Eingabestift.
- **Abb. 2b:**: Schmuckelement mit zwei getrennten Teilbereichen der transparenten, elektrisch leitfähigen Schicht für Push- beziehungsweise Slide-Eingabe.
- **Abb. 2c.**: Schmuckelement mit vier getrennten Teilbereichen der transparenten, elektrisch leitfähigen Schicht für Push- beziehungsweise Slide-Eingabe.

### GEWERBLICHE ANWENDBARKEIT

Weitere Gegenstände der Erfindung betreffen die Verwendung des Schmuckelements gemäß vorliegender Erfindung zur Energieversorgung und Funktionssteuerung, insbesondere von tragbaren elektronischen Geräten, sowie von Gegenständen, insbesondere Schmuckteile wie etwa Ringe, Ketten, Armbänder und dergleichen, enthaltend wenigstens ein Schmuckelement gemäß vorliegender Erfindung.

### BEISPIELE

Vorversuche waren bereits Gegenstand der europäischen Patentanmeldung mit dem Aktenzeichen 14 191 386, die Teil der Offenbarung der vorliegenden Anmeldung sein soll.

### MATERIALIEN

Es wurden verschiedene Schmuckelemente untersucht, die sich bezüglich Material und Geometrie unterscheiden. Die Schmuckelemente wurden aus Solarzellen und optischen Elementen aufgebaut. Die erfindungsgemäßen Beispiele wurden zusätzlich mit einer wellenlängenselektiven Schicht versehen.

**Solarzellen.** Es wurden Solarzellen des Typs Sunpower C60 (10 mm x 10 mm) verwendet.

**Schmucksteine.** Die optischen Elemente aus Glas wurden durch die dem Fachmann bekannten Verfahren aus käuflich erhältlichen Chessboard Flat Back 2493-Elementen (30 mm x 30 mm) der Firma Swarovski gefertigt.

Die optischen Elemente aus Pleximid^{®} TT70 wurden mittels Kunststoffspritzgussverfahren in einer dafür vorgefertigten Form hergestellt. Hierfür wurde eine Spritzgießmaschine der Firma Engel vom Typ e-victory 80/50 verwendet; Temperatur Massezylinder: 210°C steigend bis 280°C, Düse 280°C; Temperatur Werkzeug: 180° DS, 140° AS; Spritzdruckgrenze: 1200 bar; Spritzgeschwindigkeit: ca. 15 cm³/sec; Prägedruck: circa 800 bar; keine Lösungsmittel.

**Geometrie.** Die optischen Elemente gemäß V2-V5 sind facettierte Körper mit 12 mm Kantenlänge und quadratischer Grundfläche mit leicht abgerundeten Ecken. An der Grundfläche ist eine Abschrägung im Winkel von 45º (Phase) angebracht, so dass die tatsächlich verbleibende Grundfläche 10 mm x 10 mm beträgt. Der facettierte obere Teil mit 25 Facetten in quadratischer Anordnung bildet ein Kugelsegment. Die Gesamthöhe des Körpers beträgt 5,56 mm, an den Ecken beträgt die Höhe 1,93 mm.

## Patentansprüche

1. Schmuckelement, umfassend
(a) einen transparenten Schmuckstein mit facettierter Oberfläche umfassend konvex gekrümmte Bereiche,
(b) eine transparente, elektrisch leitfähige Schicht, die auf der facettierten Oberfläche umfassend die konvex gekrümmten Bereiche aufgebracht ist,
(c) eine wellenlängenselektive Schicht, die
(c1) auf der der facettierten und gekrümmten Oberfläche gegenüberliegenden planaren Seite oder
(c2) auf der photovoltaischen Zelle (d)
aufgebracht ist
(d) eine photovoltaische Zelle und
(e) einen elektronischen Sensor.

2. Schmuckelement nach Anspruch 1, **dadurch gekennzeichnet, dass** der Schmuckstein (a) aus Glas oder aus Kunststoff gefertigt ist.

3. Schmuckelement nach Anspruch 1, **dadurch gekennzeichnet, dass** der Schmuckstein (a) eine plan-konvexe Geometrie oder eine plan-konvex-konkave Geometrie aufweist.

4. Schmuckelement nach wenigstens einem der Ansprüche 1 bis 3, **dadurch gekennzeichnet, dass** die transparente elektrisch leitfähige Schicht (b) wenigstens eine Komponente umfasst, die gebildet wird von Cr, Ti, Zr, Indiumzinnoxid, Aluminiumdotiertem Zinkoxid, Gallium-Zink-Oxid, Titan-Zink-Oxid, Fluor-Zinn-Oxid, Antimon-Zinn-Oxid, Tantal-Zinn-Oxid oder Titan-Niob-Oxid oder eine beliebige Kombination dieser Komponenten in beliebiger Schichtabfolge.

5. Schmuckelement nach wenigstens einem der Ansprüche 1 bis 4, **dadurch gekennzeichnet, dass** die transparente, elektrisch leitfähige Schicht (b) auf wenigstens zwei getrennten Teilbereichen der gekrümmten facettierten Oberfläche aufgebracht ist.

6. Schmuckelement nach wenigstens einem der Ansprüche 1 bis 5, **dadurch gekennzeichnet, dass** die transparente, elektrisch leitfähige Schicht im Bereich von 380 - 1200 nm transparent.

7. Schmuckelement nach wenigstens einem der Ansprüche 1 bis 6, **dadurch gekennzeichnet, dass** die transparente, elektrisch leitfähige Schicht (b) wenigstens eine Transmission von 60 % aufweist.

8. Schmuckelement nach wenigstens einem der Ansprüche 1 bis 7, **dadurch gekennzeichnet, dass** die wellenlängenselektive Schicht (c) ausgewählt ist aus einer wellenlängenselektiven Beschichtung oder einer wellenlängenselektive Folie.

9. Schmuckelement nach Anspruch 8, **dadurch gekennzeichnet, dass** die wellenlängenselektive Beschichtung wenigstens ein Metall und/oder eine Metallverbindung enthält.

10. Schmuckelement nach wenigstens einem der Ansprüche 1 bis 9, **dadurch gekennzeichnet, dass** die wellenlängenselektive Schicht (c) einen Anteil des Lichtes im Bereich von 380 - 850 nm reflektiert.

11. Schmuckelement nach Anspruch 10, **dadurch gekennzeichnet, dass** die wellenlängenselektive Schicht (c) außerhalb des Reflexionsintervalls eine durchschnittliche Transmission > 80 % im Bereich von 400-1200nm aufweist, gemessen bei einem Einfallswinkel der Lichtstrahlen von 0°.

12. Schmuckelement nach wenigstens einem der Ansprüche 1 bis 11, **dadurch gekennzeichnet, dass** die wellenlängenselektive Beschichtung wenigstens eine Verbindung umfasst, die ausgewählt ist aus der Gruppe, die gebildet wird von Cr, Cr₂O₃, Ni, NiCr, Fe, Fe₂O₃, Al, Al₂O₃, Au, SiOₓ, Mn, Si, Si₃N₄, TiOₓ, Cu, Ag, Ti,CeF₃, MgF₂, Nb₂O₅, Ta₂O₅, SnO₂, ZnO₂, MgO, CeO₂, WO₃, Pr₂O₃, Y₂O₃; BaF₂, CaF₂, LaF₃, NdF₃, YF₃; ZrO₂, HfO₂, ZnS, Oxinitride von Al, Si, und SnZnO oder eine beliebige Kombination dieser Verbindungen in beliebiger Schichtabfolge.

13. Schmuckelement nach wenigstens einem der Ansprüche 1 bis 12, **dadurch gekennzeichnet, dass** die photovoltaische Zelle (d) eine rückseitenkontaktierte Solarzelle ist.

14. Schmuckelement nach wenigstens einem der Ansprüche 1 bis 13, **dadurch gekennzeichnet, dass** der elektronische Sensor (e) einen kapazitiven Sensor enthält.

15. Verwendung des Schmuckelements gemäß wenigstens einem der Ansprüche 1 bis 14 zur Funktionssteuerung und zur Energieversorgung von elektronischen Geräten.
